# EUROPEAN PATENT SPECIFICATION

(11) **EP 3 745 142 B1**
(45) Date of publication and mention of the grant of the patent: **04.10.2023**
(21) Application number: 20169599.6
(22) Date of filing: 15.04.2020
(51) Int. Cl.: G01R 1/073

(54) **PROBE CARD AND SWITCH MODULE**
SONDENKARTE UND SCHALTMODUL
CARTE DE SONDE ET MODULE DE COMMUTATION

(30) Priority: 31.05.2019 TW 108119092; 04.12.2019 TW 108144391
(43) Date of publication of application: 02.12.2020
(73) Proprietor: MPI Corporation, Chu-pei City, Hsinchu County 302 (TW)
(72) Inventor: LIN, Chin-Yi, 302 Chu-pei City, Hsinchu County (TW); WU, Hsueh-Chih, 302 Chu-pei City, Hsinchu County (TW); LIN, Che-Wei, 302 Chu-pei City, Hsinchu County (TW); WU, Ko-Chun, 302 Chu-pei City, Hsinchu County (TW); WU, Ting-Ju, 302 Chu-pei City, Hsinchu County (TW); SU, Keng-Min, 302 Chu-pei City, Hsinchu County (TW)
(74) Representative: Viering, Jentschura & Partner mbB Patent- und Rechtsanwälte

(56) References cited:
- WO-A1-2018/182719
- KR-B1- 100 996 927
- US-A1- 2004 207 420
- US-A1- 2008 054 918
- US-A1- 2009 015 275
- US-A1- 2012 146 677
- US-A1- 2016 109 483
- US-A1- 2016 187 384

## Description

### BACKGROUND

### Technical Field

The instant disclosure relates to a probe card and a switch module.

### Related Art

A manufacturing method for integrated circuit (IC) chips includes forming several dies on a wafer, cutting the wafer into several independent dies, and then packaging the dies individually. The dies with different functions may have different sizes. For a die with complicated functions, the size of the die is larger, and the number of contact points on the larger-sized die is more. As a result, the distance between the contact points of the large-sized die is quite narrow. On the other hand, though the number of the contact points on the die with simple functions is lesser, the distance between the contact points of the die with simple functions is still narrow due to the die having a smaller size. Consequently, the dies may perform electrical connections with the circuit board hardly.

To allow the circuits in the dies to be electrically connected to the circuit board, the spatial distribution of the contact points on the dies has to be enlarged, and the step is called space transform. The space transform step may be implemented by soldering the dies on an IC carrier plate. The IC carrier plate has an upper surface and a lower surface, the spatial distribution of upper contact points at the upper surface is the same as the spatial distribution of the contact points of corresponding dies; conversely, the spatial distribution of lower contact points at the lower surface is rather looser, with respect to the spatial distribution of the contact points of the corresponding dies. A circuit layout is configured between the upper surface and the lower surface, so that the upper contact points at the upper surface and the lower contact points at the lower surface are electrically connected to each other. Accordingly, the spatial distribution of the contact points of a die can be enlarged through the IC carrier plate.

Before the dies are combined with the IC carrier plate, generally a testing procedure, e.g., probing with a probe card, is to apply to the dies. In order to detect the dies on the wafer, the probe distribution on the probe card has to be the same as the distribution of the contact points on the dies. As a result, the probes on the probe card are arranged in a dense configuration as well. As mentioned above, due to the dense configuration of the contact points on the dies, the direct electrical connection between the contact points on the dies and the circuit board may be difficult. Similarly, the same issue may occur to the dense-configured probes upon the probes are to be electrically connecting to a test circuit board directly. Consequently, "a spatial transform device" is to be provided for the probes, so that the spatial transform step for the probes can be implemented and then the probes are electrically connected to the test circuit board.

The spatial transform device, similar to the IC carrier, has a top surface and a bottom surface. The distribution of contact points at the bottom surface for connecting to the probes is the same as the dense distribution of the contact points of the probes; conversely, the distribution of contact points at the top surface facing the test circuit board is rather looser, with respect to the distribution of the contact points of the probes.

US2012146677A discloses a probe card that facilitates a wiring connection, reducing
working time and preventing a working error and includes a main circuit board having an opening in its center. A reinforcement member has a lower end coupled to that opening to prevent deforming of the board. A sub-circuit board electrically connected to the main board is seated on an upper side of the reinforcement member. A space transformer is positioned on a lower portion of the opening of the main board. A plurality of wires have both ends inserted into through holes in the sub-circuit board and space transformer to electrically connect them. Probes are provided on a lower portion of the space transformer, each having one end in contact with the wire inserted into the through-hole of the space transformer and the other end in contact with a wafer to be tested.

US2016109483A1 discloses an electrical contacting device for electrical physical contact with a specimen, particularly wafers, taking place in a contacting direction, with at least one conductor substrate which can be electrically connected to a testing device, at least one contact distance transformer and at least one contact head having electrical contact elements, particularly resilient contact elements, preferably serving to compensate different physical contact distances existing in the contacting direction particularly at the contact elements.

US 2004207420A1 discloses a modularized probe card with a coaxial transmitter. At least a coaxial transmitter is modularized and installed between a first printed circuit board and a second printed circuit board. The coaxial transmitter has a first connector and a second connector correspondingly connecting two ends of each coaxial cable of the coaxial transmitter for electrically connecting corresponding in location to first printed circuit board and second printed circuit board. A probe head is bonded on second printed circuit board. The second connector of the coaxial transmitter is connected with the second printed circuit board in a plug-in and pull-away type.

In a spatial transform device known to the inventor, the microhole plate is directly wired to the test circuit board when the spatial transform device is to be electrically connected to the test circuit board. As a result, the wire traces are intersected with each other, thereby causing the interferences between the signals in the wires easily. Moreover, since the lengths of the wires are different, the signals in the wires have different time sequences, thereby affecting the accuracy of the result for electrical testing.

### SUMMARY

In view of these, one embodiment of the instant disclosure provides a switch module according to claim 1.

Accordingly, the switch module is adapted to be electrically connected to a corresponding test circuit board through the switch plate, so that the wires are not intersected with each other and have a uniform length. Hence, the problem of interferences between signals in different wires and the problem of test signals with different time sequences as mentioned above can be improved.

### BRIEF DESCRIPTION OF THE DRAWINGS

The disclosure will become more fully understood from the detailed description given herein below for illustration only, and thus not limitative of the disclosure, wherein:
Fig. 1 illustrates an exploded cross-sectional view of a switch module according to an example not according to the claimed invention;
Fig. 2 illustrates an assembled cross-sectional view of the switch module of the example;
Fig. 3 illustrates an assembled cross-sectional view of a switch module according to an exemplary embodiment of the instant disclosure, where the switch module has a positioning film and an inner layer circuit layout;
Fig. 4 illustrates an assembled cross-sectional view of a switch module according to further another exemplary embodiment of the instant disclosure, where the switch module has a positioning film and external circuit traces;
Fig. 5 illustrates an exploded cross-sectional view of a probe card according to an exemplary embodiment of the instant disclosure;
Fig. 6 illustrates an assembled cross-sectional view of the probe card of the exemplary embodiment;
Fig. 7 illustrates a schematic view showing the switch module of the probe card of the exemplary embodiment is electrically connected to the test circuit board; and
Fig. 8 illustrates a top schematic view of the probe card of the exemplary embodiment.

### DETAILED DESCRIPTION

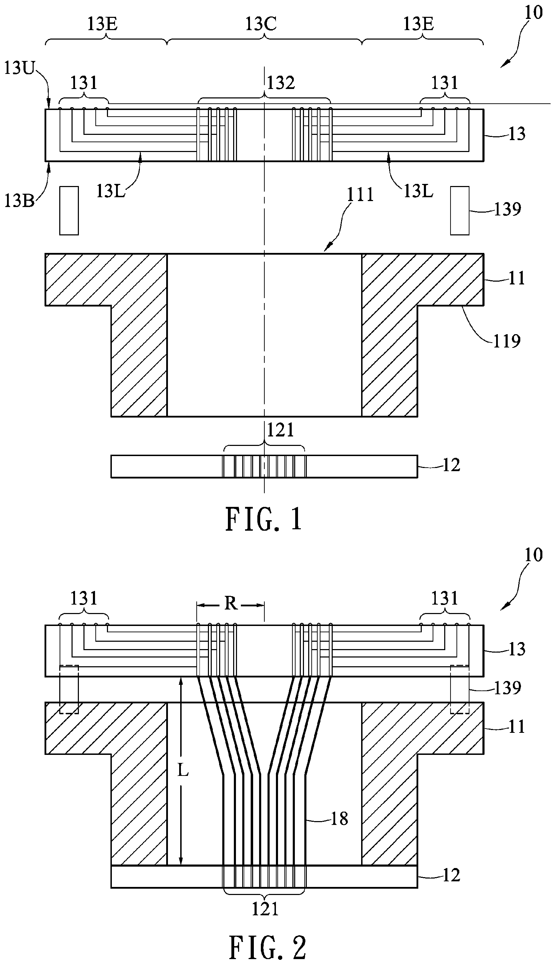

Please refer to Figs. 1 and 2, respectively illustrating an exploded cross-sectional view and an assembled cross-sectional view of a switch module according to an example not falling within the subject-matter of the claims. In one or more examples, the switch module 10 comprises a base 11, a microhole plate 12, and a switch plate 13. The material of the base 11, in general, may be stainless steel, and a center portion of the base 11 has a hollow portion 111. The material of the microhole plate 12, in general, may be ceramic materials, and the microhole plate 12 is disposed below the base 11. The switch plate 13 may be a single-layered circuit board or a multilayered circuit board, and the switch plate 13 is disposed above the base 11. The microhole plate 12 comprises a plurality of first microholes 121 facing the hollow portion 111 of the base 11. The switch plate 13 comprises a top surface 13U and a bottom surface 13B. The bottom surface 13B faces the base 11, and the top surface 13U comprises a plurality of upper contact points 131.

In some examples, the switch plate 13 is not directly disposed on the base 11; instead, the switch plate 13 is disposed above the base 11 using steel posts 139, so that an included angle between the wires 18 and the switch plate 13 can be reduced, thereby reducing the bending angle of the wires 18. Hence, the reliability and the durability of the electrical connection between the wires 18 and the switch plate 13 can be increased. In some examples, the switch plate 13 comprises a central region 13C and an edge region 13E surrounding the central region 13C, and the upper contact points 131 are in the edge region 13E. In some examples, the edge region 13E is defined as a region of the switch plate 13 whose projection in the normal direction of the switch plate 13 does not overlap with the hollow portion 111 of the base 11. In some examples, the switch plate 13 is of a circular shape and has a radius, the central region 13C is defined as a circular region from the center of circle of the switch plate 13 to a length of 0.7 times of the radius of the switch plate 13, and the edge region 13E is defined as an annular region of the switch plate 13 out of the circular region. In some examples, the projection of the central region 13C in the normal direction of the surface of the switch plate 13 is just overlapped with the hollow portion 111; in other words, in these examples, the periphery of the projection of the central region 13C is substantially aligned with the periphery of the hollow portion 111. It is understood that, in the case that the upper contact points 131 are configured in the edge region 13E of the switch plate 13, that is, in the case that the upper contact points 131 are configured close to the periphery of the switch plate 13, the electrical connection between the upper contact points 131 and a test circuit board which will be described in the following paragraphs can be facilitated.

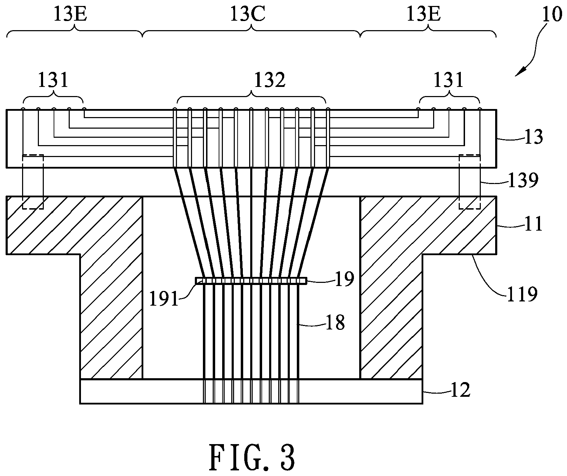

As shown in Fig. 3, according to the invention, the switch module 10 further comprises a positioning film 19. The positioning film 19 is used to guide the wires 18 passing through the microhole plate 12 to be aligned orderly, so that the operator can determine the order for each of the wires 18. The positioning film 19 may be made of polymer materials and flexible. The positioning film 19 is disposed between the microhole plate 12 and the switch plate 13, and the positioning film 19 is located above the first microholes 121 of the microhole plate 12. In some embodiments, the switch plate 13 further comprises an inner layer circuit layout 13L located between the top surface 13U and the bottom surface 13B. The inner layer circuit layout 13L is used to allow the wires 18 to be electrically connected to the upper contact points 131 at the top surface 13U through the inner layer circuit layout 13L. The positioning film 19 comprises a plurality of second microholes 191 respectively corresponding to the first microholes 121. Moreover, a distance between two adjacent second microholes 191 is equal to a distance between two adjacent first microholes 121. In other words, the segments of the wires 18 between the positioning film 19 and the microhole plate 12 do not have the fan-out layout yet; instead, the fan-out layout of the wires 18 starts from the segments of the wires 18 between the positioning film 19 and the bottom surface 13B of the switch plate 13.

As above, in this embodiment, after the wires 18 pass through the positioning film 19, the wires 18 extend to the switch plate 13. The distance between two adjacent wires 18 gradually becomes larger as the two adjacent wires 18 get closer to the bottom surface 13B of the switch plate 13. Next, the wires 18 further pass through the vias 132 of the switch plate 13 and are soldered on the top surface 13U of the switch plate 13. A distance between two adjacent vias 132 are fixed. In other words, if the distance between two adjacent first microholes 121 of the microhole plate 12 is defined as P1, the distance between two adjacent second microholes 191 of the positioning film 19 is defined as P2, and the distance between two adjacent vias 132 of the switch plate 13 is defined as P3, then P1=P2<P3, and a distance between two adjacent wires 18 gradually approaches to reach P3, from the segments of the wires 18 at the positioning film 19 to the segments of the wires 18 closer to the switch plate 13.

During the installation of the wires 18, firstly the positioning film 19 is disposed on the microhole plate 12, and the second microholes 191 and the first microholes 121 are aligned with each other in a one-by-one manner. Then, the wires 18 respectively pass through the second microholes 191 and respectively pass through the first microholes 121 from top to bottom. Hence, the segments of the wires 18 between the positioning film 19 and the microhole plate 12 are in a vertical configuration; namely, the wires 18 are of a linear configuration and do not have bent portions, so that the wires 18 are spaced with a fixed interval and do not intersect with each other. therefore, the electrical abnormality issue caused by the intersection of the wires 18 can be eliminated. Furthermore, the positioning film 19 can be provided for arranging the wires 18, so that the operator can perform the subsequent electrical connection procedure in a convenient manner. After the wires 18 are arranged, a glue material (e.g., epoxy resin) may be applied to fill the space between the positioning film 19 and the microhole plate 12, so that the distance between the positioning film 19 and the microhole plate 12 can be fixed. Moreover, the segments of the wires 18 between the positioning film 19 and the microhole plate 12 can be spaced by the glue material, thereby further ensuring the segments of the wires 18 between the positioning film 19 and the microhole plate 12 not being intersected with each other.

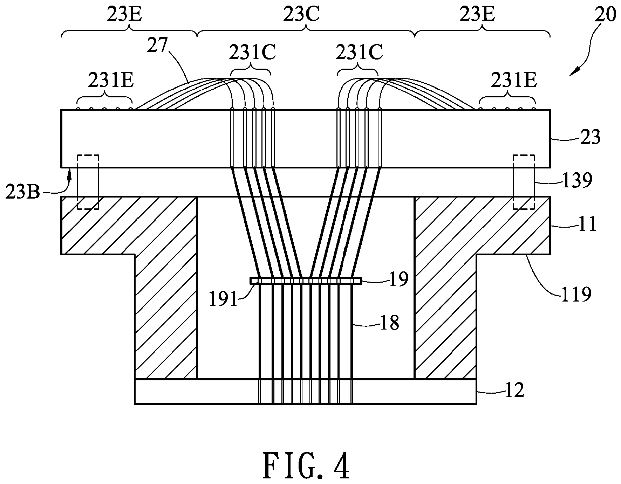

As shown in Fig. 4, in some embodiments, the switch plate 23 comprises a plurality of first upper contact points 231C and a plurality of second upper contact points 231E electrically connected to the first upper contact points 231C, respectively. The first upper contact points 231C are in the central region 23C, and the second upper contact points 231E are in the edge region 23E. In some embodiments, the switch plate 23 further comprises intermediate circuit traces 27. The intermediate circuit traces 27 are used to electrically connect the first upper contact points 231C to the second upper contact points 231E, respectively. Similarly, in these embodiments, the segments of the wires 18 between the positioning film 19 and the microhole plate 12, as shown in Fig. 4, do not have the fan-out layout; instead, the fan-out layout of the wires 18 starts from the segments of the wires 18 between the positioning film 19 and the bottom surface 23B of the switch plate 23.

In some embodiments, as shown in Figs. 1 and 2, a distance L between the bottom surface 13B of the switch plate 13 and an upper surface off the microhole plate 12 is greater than 4 mm. Because it is understood that, the thickness of a test circuit board is usually greater than 4 mm, the distance L between the bottom surface 13B of the switch plate 13 and the upper surface of the microhole plate 12 is configured to be greater than 4 mm, so that when the switch module 10 is assembled with the test circuit board, the top surface 13U of the switch plate 13 can protrude out of the upper surface of the test circuit board, and the microhole plate 12 can protrude out of the lower surface of the test circuit board. Moreover, in some embodiments, the ensemble of contact positions between the wires 18 and the bottom surface 13B of the switch plate 13 forms a circular soldering region or a rectangular soldering region. A radius of the circular soldering region is defined as R, while a side length of the rectangular soldering region is defined as 2R. The distance between the bottom surface 13B of the switch plate 13 and the upper surface of the microhole plate 12 is defined as L, and a value of R/L is in a range between 0.1 and 7.5. In some embodiments, the distance L between the bottom surface 13B of the switch plate 13 and the upper surface of the microhole plate 12 is in a range between 4 mm to 40 mm, and the radius of the circular soldering region is in a range between 4 mm to 30 mm.

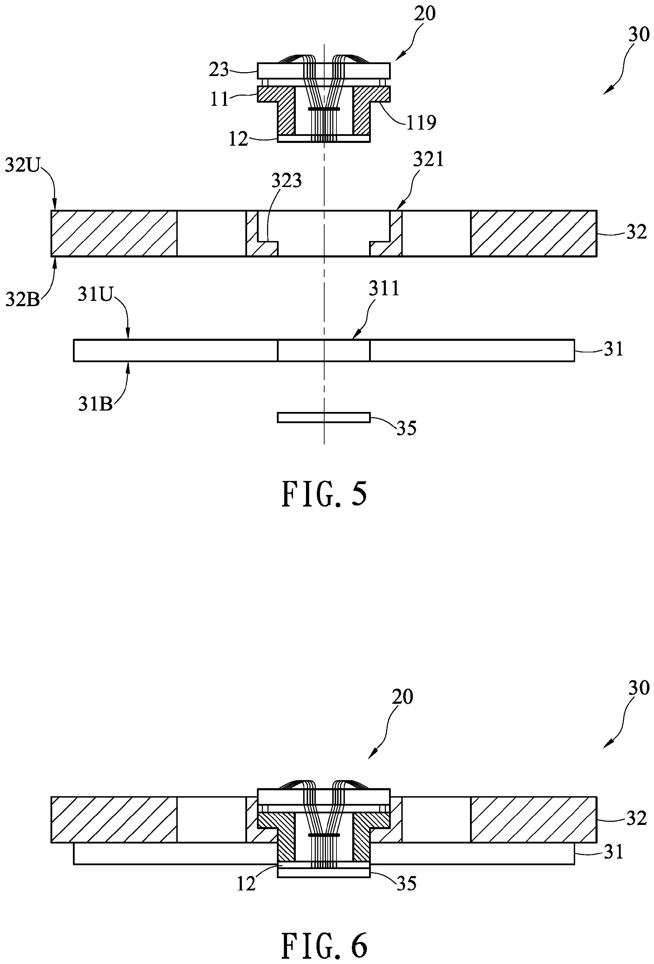

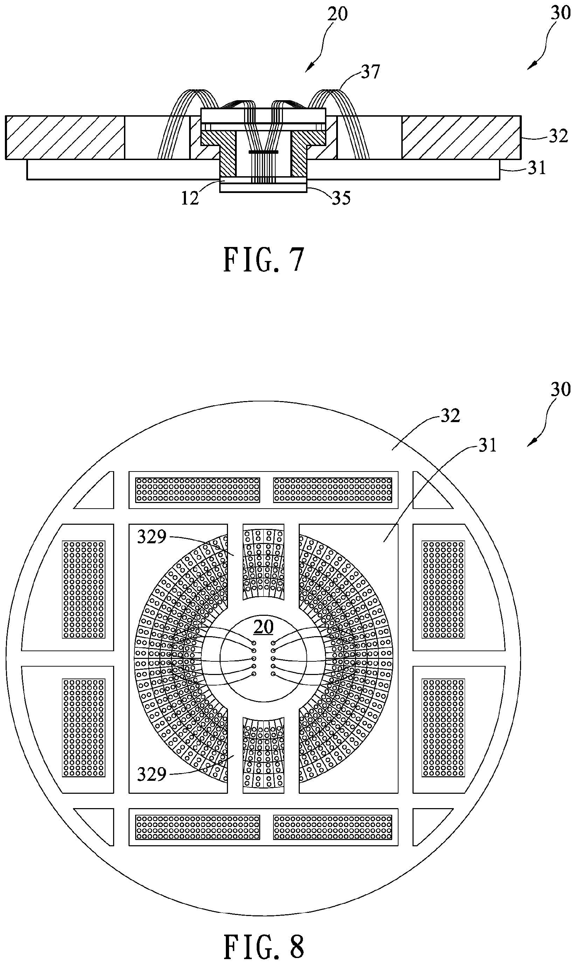

Please refer to Figs. 5 to 8. Fig. 5 illustrates an exploded cross-sectional view of a probe card according to an exemplary embodiment of the instant disclosure. Fig. 6 illustrates an assembled cross-sectional view of the probe card of the exemplary embodiment. Fig. 7 illustrates a schematic view showing the switch module of the probe card of the exemplary embodiment is electrically connected to the test circuit board. Fig. 8 illustrates a top schematic view of the probe card of the exemplary embodiment. In one or some embodiments, the probe card 30 comprises a test circuit board 31, a reinforcement member 32, a switch module 20, and a test head 35. The test circuit board 31 comprises an upper surface 31U, a bottom surface 31B, and a central hole 311. The upper surface 31U is defined as the tester side of the test circuit board 31; that is, a surface of the test circuit board 31 adapted to be connected to a test device. The lower surface 31B is defined as the wafer side of the test circuit board 31; that is, a surface of the test circuit board 31 facing the wafer to be tested. The reinforcement member 32 may be a frame made of aluminum or aluminum alloy. The reinforcement member 32 is disposed on the upper surface 31U of the test circuit board 31 so as to improve the stiffness of the test circuit board 31. The reinforcement member 32 comprises a central carrier 321 disposed on a central portion thereof and the central carrier 321 corresponds to the central hole 311 of the test circuit board 31. Moreover, the central carrier 321 is connected to a main body of the reinforcement member 32 with four bridging members 329. In some embodiments, the central carrier 321 may be connected to the main body of the reinforcement member 32 just with two bridging members 321 or even with bridging members in other shapes, depending on the model number of the test circuit board 31.

Upon the assembly of the probe card 30, the switch module 20 is inserted into the central carrier 321 from an upper surface 32U of the reinforcement member 32, and the microhole plate 12 of the switch module 20 protrudes out of a lower surface 32B of the reinforcement member 32 and of the lower surface 31B of the test circuit board 31, and then the microhole plate 12 is electrically connected to the test head 35. In some embodiments, an inner surface of the central carrier 321 has a flange 323, as shown in Fig. 5. When the switch module 20 is received in the central carrier 321, the flange 323 abuts against an outer periphery 119 of the base 11. Therefore, the movement of the switch module 20 is limited by the flange 323 and cannot further pass through the reinforcement member 32 from top to bottom in a vertical direction.

In some embodiments, the outer diameter of the switch plate 23 may be as larger as possible, for example, the outer diameter of the switch plate 23 may be greater than a hole diameter of the central hole 311 of the test circuit board 31.

In some embodiments, a material of the wires 18 is different from a material of the intermediate circuit traces 27 and is also different from a material of the external circuit traces 37. Since the wire diameter of each of the wires 18 is not greater than 50 micrometers, e.g., may be 35 micrometer, the wires 18 may be broken easily when made of common metal lines. The material of the wires 18 may be a metal material which is not broken easily under the wire diameter requirement. For example, the wires 18 may be made of copper-tungsten alloy or copper-silver alloy, or may be made of the aforementioned alloys doped with rhenium, palladium, or beryllium. Since the wire diameter of each of the wires 18 is quite small and the wires 18 are arranged densely, the wires 18 can be arranged properly through the configuration of the positioning film 19, so that operators can perform the procedures conveniently. In some embodiments, a ratio of a length of a longest wire of the wires 18 and a length of a shortest wire of the wires 18 is less than 1.1. In other words, substantially, the lengths of the wires 18 are configured to be maintained in a uniform length as much as possible; even if the wires 18 have different lengths, the length of the longest wire cannot exceed the length of the shortest wire by 10% of the length of the shortest wire. Moreover, a sealing glue (e.g., epoxy resin) may be filled in the space between the microhole plate 12 and the switch plate 13 to seal the wires 18 so as to protect the wires 18, thereby improving the weatherability of the entire switch module.

It is understood that, in order to explain the structures of the switch module and the probe card conveniently, the elements in the drawings are not illustrated to actual scale.

While the instant disclosure has been described by the way of example and in terms of the preferred embodiments, it is to be understood that the invention need not be limited to the disclosed embodiments.

## Claims

1. A switch module (10, 20) adapted to be electrically connecting a plurality of probes of a test head (35) to a plurality of upper contact points of an upper surface (31U) of a test circuit board (31), wherein the switch module (10, 20) comprises:
a base (11) comprising a hollow portion (111);
a microhole plate (12) disposed below the base (11), wherein the microhole plate (12) comprises a plurality of first microholes (121) facing the hollow portion (111);
a switch plate (13, 23) disposed above the base (11), wherein an outer diameter of the switch plate (13, 23) is greater than a hole size of the hollow portion (111), the switch plate (13, 23) comprises a top surface (13U), a bottom surface (13B), and a plurality of vias (132), the bottom surface (13B) of the switch plate (13, 23) faces the base (11), the top surface (13U) of the switch plate (13, 23) comprises a plurality of upper contact points (131), the vias (132) are extending from the top surface (13U) of the switch plate (13, 23) to the bottom surface (13B) of the switch plate (13, 23);
a plurality of wires (18) respectively passing through the first microholes (121) of the microhole plate (12) and the vias (132) of the switch plate (13, 23), wherein the wires (18) electrically connect the microhole plate (12) to the upper contact points (131) of the top surface (13U) of the switch plate (13, 23);
a plurality of external circuit traces (37) for respectively and electrically connecting the upper contact points (131) of the switch plate (13, 23) to the upper contact points of the upper surface (31U) of the test circuit board (31); and
wherein a distance between two adjacent vias (132) of the switch plate (13, 23) is greater than a distance between two adjacent first microholes (121) of the microhole plate (12), and a ratio of a length of a longest wire of the wires (18) and a length of a shortest wire of the wires (18) is less than 1.1; **characterised in that** the switch module (10,20) further comprises:
a positioning film (19), disposed between the microhole plate (12) and the switch plate (13, 23) and above the first microholes (121) of the microhole plate (12), wherein the positioning film (19) comprises a plurality of second microholes (191) respectively corresponding to the first microholes (121), the wires (18) respectively pass through the second microholes (191) of the positioning film (19), a distance between two adjacent vias (132) of the switch plate (13, 23) is greater than a distance between two adjacent second microholes (191) of the positioning film (19), and the distance between two adjacent second microholes (191) of the positioning film (19) is equal to the distance between two adjacent first microholes (121) of the microhole plate (12).

2. The switch module (10) according to claim 1, wherein a distance between the top surface (13U) of the switch plate (13) and an upper surface of the microhole plate (12) is greater than 4 mm.

3. The switch module (10) according to claim 1, wherein an ensemble of contact positions between the wires (18) and the bottom surface (13B) of the switch plate (13) forms a circular soldering region, a radius of the circular soldering region is defined as R, a distance between the bottom surface (13B) of the switch plate (13) and an upper surface of the microhole plate (12) is defined as L, and a value of R/L is in a range between 0.1 and 7.5.

4. The switch module (10) according to claim 1, wherein an ensemble of contact positions between the wires (18) and the bottom surface (13B) of the switch plate (13) forms a rectangular soldering region, a side length of the rectangular soldering region is defined as 2R, a distance between the bottom surface (13B) of the switch plate (13) and an upper surface of the microhole plate (12) is defined as L, and a value of R/L is in a range between 0.1 and 7.5.

5. A probe card (30) comprising:
a test circuit board (31) comprising an upper surface (3 1U), a lower surface (31B), and a central hole (311);
a reinforcement member (32) disposed on the upper surface (31U) of the test circuit board (31), wherein the reinforcement member (32) comprises a central carrier (321) corresponding to the central hole (311);
a switch module (10, 20) according to any one of claims 1 to 5, wherein the switch module (10, 20) is received in the central carrier (321) of the reinforcement member (32), and wherein the wires (18) do not intersect with each other and have a uniform length

6. The probe card (30) according to claim 5, wherein the switch plate (13, 23) comprises a central region (13C, 23C) and an edge region (13E, 23E) surrounding the central region (13C, 23E), and the upper contact points (131) are in the edge region (13E, 23E).

7. The probe card (30) according to claim 6, wherein a projection of the edge region (13E, 23E) in a normal direction of the switch plate is not overlapped with the hollow portion (111) of the base (11).

8. The probe card (30) according to claim 7, wherein the switch plate (13, 23) further comprises an inner layer circuit layout (13L) located between the top surface (13U) and the bottom surface (13B), the wires (18) are electrically connected to the upper contact points (131) of the switch plate (13, 23) through the inner layer circuit layout (13L).

9. The probe card (30) according to claim 6, wherein the switch module (10, 20) further comprises a plurality of intermediate circuit traces (27), the switch plate (13, 23) further comprises a central region (13C, 23C) and an edge region (13E, 23E) surrounding the central region (13C, 23C); the upper contact points of the switch plate (13, 23) are divided into a plurality of first upper contact points (231C) and a plurality of second upper contact points (231E), the first upper contact points (231C) are in the central region (13C, 23C), and the second upper contact points (13E, 231E) are in the edge region (13E, 23E); the wires (18) electrically connect the microhole plate (12) to the first upper contact points (231C) of the switch plate (13, 23), and the intermediate circuit traces (27) electrically connect the first upper contact points (231C) to the second upper contact points (231E).

10. The probe card (30) according to claim 6, wherein a projection of the edge region (13E, 23E) in a normal direction of the switch plate is not overlapped with the hollow portion (111) of the base (11).

11. The probe card (30) according to claim 6, wherein a material of the wires (18) is different from a material of the external circuit traces (37) and is different from a material of the intermediate circuit traces (13L).

12. The probe card (30) according to claim 5, wherein an inner surface of the central carrier (321) has a flange (323) abutted against an outer periphery (119) of the base (11).

13. The probe card (30) according to claim 5, wherein the microhole plate (12) is exposed from the lower surface (31B) of the test circuit board (31).

14. The probe card (30) according to claim 5, wherein an outer diameter of the switch plate (13, 23) is greater than a hole diameter of the central hole (311) of the test circuit board (31).

## Patentansprüche

1. Ein Schaltmodul (10, 20), welches dazu geeignet ist, eine Mehrzahl von Testern eines Testkopfes (35) mit einer Mehrzahl von oberen Kontaktpunkten einer oberen Fläche (31U) einer Testleiterplatte (31) elektrisch zu verbinden, wobei das Schaltmodul (10, 20) aufweist
eine Basis (11) mit einem hohlen Abschnitt (111),
eine Mikrolochplatte (12), welche unterhalb der Basis (11) angeordnet ist, wobei die Mikrolochplatte (12) eine Mehrzahl von ersten Mikrolöchern (121) aufweist, welche dem hohlen Abschnitt (111) gegenüberliegen,
eine Schaltplatte (13, 23), welche oberhalb der Basis (11) angeordnet ist, wobei ein Außendurchmesser der Schaltplatte (13, 23) größer ist als eine Lochgröße des hohlen Abschnitts (111), wobei die Schaltplatte (13, 23) eine obere Fläche (13U), eine untere Fläche (13B) und eine Mehrzahl von Durchgangslöchern (132) aufweist, die untere Fläche (13B) der Schaltplatte (13, 23) der Basis (11) zugewandt ist, die obere Fläche (13U) der Schaltplatte (13, 23) eine Mehrzahl von oberen Kontaktpunkten (131) aufweist, die Durchgangslöcher (132) sich von der oberen Fläche (13U) der Schaltplatte (13, 23) aus hin zur unteren Fläche (13B) der Schaltplatte (13, 23) erstrecken,
eine Mehrzahl von Drähten (18), welche jeweilig durch die ersten Mikrolöcher (121) der Mikrolochplatte (12) und die Durchgangslöcher (132) der Schaltplatte (13, 23) verlaufen, wobei die Drähte (18) die Mikrolochplatte (12) mit den oberen Kontaktpunkten (131) der oberen Fläche (13U) der Schaltplatte (13, 23) elektrisch verbinden;
eine Mehrzahl von externen Leiterbahnen (37) zur jeweiligen und elektrischen Verbindung der oberen Kontaktpunkte (131) der Schaltplatte (13, 23) mit den oberen Kontaktpunkten der oberen Fläche (31U) der Testleiterplatte (31); und
wobei ein Abstand zwischen zwei benachbarten Durchgangslöchern (132) der Schaltplatte (13, 23) größer ist als ein Abstand zwischen zwei benachbarten ersten Mikrolöchern (121) der Mikrolochplatte (12), und ein Verhältnis einer Länge eines längsten Drahtes der Drähte (18) und einer Länge eines kürzesten Drahtes der Drähte (18) kleiner als 1,1 ist, **gekennzeichnet dadurch, dass** das Schaltmodule (10, 20) ferner aufweist:
eine Positionierungsfolie (19), welche zwischen der Mikrolochplatte (12) und der Schaltplatte (13, 23) angeordnet ist und sich über den ersten Mikrolöchern (121) der Mikrolochplatte (12) befindet, wobei die Positionierungsfolie (19) eine Mehrzahl von zweiten Mikrolöchern (191) aufweist, welche jeweils mit den ersten Mikrolöchern (121) korrespondieren, wobei die Drähte (18) jeweils durch die zweiten Mikrolöcher (191) der Positionierungsfolie (19) verlaufen, ein Abstand zwischen zwei benachbarten Durchgangslöchern (132) der Schaltplatte (13, 23) größer ist als ein Abstand zwischen zwei benachbarten zweiten Mikrolöchern (191) der Positionierungsfolie (19), und der Abstand zwischen zwei benachbarten zweiten Mikrolöchern (191) der Positionierungsfolie (19) gleich dem Abstand zwischen zwei benachbarten ersten Mikrolöchern (121) der Mikrolochplatte (12) ist.

2. Das Schaltmodul (10) nach Anspruch 1, wobei ein Abstand zwischen der oberen Fläche (13U) der Schaltplatte (13) und einer oberen Fläche der Mikrolochplatte (12) größer als 4 mm ist.

3. Das Schaltmodul (10) nach Anspruch 1, wobei eine Gruppe von Kontaktpositionen zwischen den Drähten (18) und der unteren Fläche (13B) der Schaltplatte (13) einen kreisförmigen Lötbereich bildet, ein Radius des kreisförmigen Lötbereichs als R definiert ist, ein Abstand zwischen der unteren Fläche (13B) der Schaltplatte (13) und einer oberen Fläche der Mikrolochplatte (12) als L definiert ist, und ein Wert von R/L in einem Bereich zwischen 0,1 und 7,5 liegt.

4. Das Schaltmodul (10) nach Anspruch 1, wobei eine Gruppe von Kontaktpositionen zwischen den Drähten (18) und der unteren Fläche (13B) der Schaltplatte (13) einen rechteckigen Lötbereich bildet, eine Seitenlänge des rechteckigen Lötbereichs als 2R definiert ist, ein Abstand zwischen der unteren Fläche (13B) der Schaltplatte (13) und einer oberen Fläche der Mikrolochplatte (12) als L definiert ist, und ein Wert von R/L in einem Bereich zwischen 0,1 und 7,5 liegt.

5. Eine Prüfkarte (30), aufweisend:
eine Testleiterplatte (31) mit einer oberen Fläche (31U), einer unteren Fläche (31B) und einem zentralen Loch (311),
ein Verstärkungselement (32), welches auf der oberen Fläche (31U) der Testleiterplatte (31) angeordnet ist, wobei das Verstärkungselement (32) einen zentralen Träger (321) aufweist, welcher mit dem zentralen Loch (311) korrespondiert,
ein Schaltmodul (10, 20) nach einem der Ansprüche 1 bis 5, wobei das Schaltmodul (10, 20) in dem zentralen Träger (321) des Verstärkungselements (32) aufgenommen ist, und
wobei die Drähte (18) sich nicht miteinander kreuzen und eine einheitliche Länge aufweisen.

6. Die Prüfkarte (30) nach Anspruch 5, wobei die Schaltplatte (13, 23) einen zentralen Bereich (13C, 23C) und einen den zentralen Bereich (13C, 23E) umgebenden Randbereich (13E, 23E) aufweist und die oberen Kontaktpunkte (131) im Randbereich (13E, 23E) liegen.

7. Die Prüfkarte (30) nach Anspruch 6, wobei eine Projektion des Randbereichs (13E, 23E) in einer Normalrichtung der Schaltplatte nicht mit dem hohlen Abschnitt (111) der Basis (11) überlappt ist.

8. Die Prüfkarte (30) nach Anspruch 7, wobei die Schaltplatte (13, 23) ferner eine Innenschicht-Schaltungsanordnung (13L) aufweist, welche zwischen der oberen Fläche (13U) und der unteren Fläche (13B) angeordnet ist, wobei die Drähte (18) über die Innenschicht-Schaltungsanordnung (13L) elektrisch mit den oberen Kontaktpunkten (131) der Schaltplatte (13, 23) verbunden sind.

9. Die Prüfkarte (30) nach Anspruch 6, wobei das Schaltmodul (10, 20) ferner eine Mehrzahl von Zwischenleiterbahnen (27) aufweist, wobei die Schaltplatte (13, 23) ferner einen zentralen Bereich (13C, 23C) und einen den zentralen Bereich (13C, 23C) umgebenden Randbereich (13E, 23E) aufweist, die oberen Kontaktpunkte der Schaltplatte (13, 23) in eine Mehrzahl von ersten oberen Kontaktpunkten (231C) und eine Mehrzahl von zweiten oberen Kontaktpunkten (231E) unterteilt sind, sich die ersten oberen Kontaktpunkte (231C) in dem zentralen Bereich (13C, 23C) und die zweiten oberen Kontaktpunkte (13E, 231E) in dem Randbereich (13E, 23E) befinden, die Drähte (18) die Mikrolochplatte (12) mit den ersten oberen Kontaktpunkten (231C) der Schaltplatte (13, 23) elektrisch verbinden, und die Zwischenleiterbahnen (27) die ersten oberen Kontaktpunkte (231C) mit den zweiten oberen Kontaktpunkten (231E) elektrisch verbinden.

10. Die Prüfkarte (30) nach Anspruch 6, wobei eine Projektion des Randbereichs (13E, 23E) in einer Normalrichtung der Schaltplatte nicht mit dem hohlen Abschnitt (111) der Basis (11) überlappt ist.

11. Die Prüfkarte (30) nach Anspruch 6, wobei ein Material der Drähte (18) von einem Material der externen Leiterbahnen (37) und von einem Material der Zwischenleiterbahnen (13L) verschieden ist.

12. Die Prüfkarte (30) nach Anspruch 5, wobei eine Innenfläche des zentralen Trägers (321) einen Flansch (323) aufweist, welcher an einem Außenumfang (119) der Basis (11) anliegt.

13. Die Prüfkarte (30) nach Anspruch 5, wobei die Mikrolochplatte (12) von der unteren Fläche (31B) der Testleiterplatte (31) aus exponiert ist.

14. Prüfkarte (30) nach Anspruch 5, wobei ein Außendurchmesser der Schaltplatte (13, 23) größer ist als ein Lochdurchmesser des zentralen Lochs (311) der Testleiterplatte (31).

## Revendications

1. Module de commutation (10, 20) adapté pour connecter électriquement une pluralité de sondes d'une tête de test (35) à une pluralité de points de contact supérieurs d'une surface supérieure (31U) d'une carte de circuit imprimé de test (31), dans lequel le module de commutation (10, 20) comprend :
une base (11) comprenant une partie creuse (111) ;
une plaque à micro-trous (12) disposée sous la base (11), dans lequel la plaque à micro-trous (12) comprend une pluralité de premiers micro-trous (121) faisant face à la partie creuse (111) ;
une plaque de commutation (13, 23) disposée au-dessus de la base (11), dans lequel un diamètre extérieur de la plaque de commutation (13, 23) est supérieur à une taille de trou de la partie creuse (111), la plaque de commutation (13, 23) comprend une surface supérieure (13U), une surface inférieure (13B), et une pluralité de trous de liaison (132), la surface inférieure (13B) de la plaque de commutation (13, 23) fait face à la base (11), la surface supérieure (13U) de la plaque de commutation (13, 23) comprend une pluralité de points de contact supérieurs (131), les trous de liaison (132) s'étendent de la surface supérieure (13U) de la plaque de commutation (13, 23) à la surface inférieure (13B) de la plaque de commutation (13, 23) ;
une pluralité de fils (18) traversant respectivement les premiers micro-trous (121) de la plaque à micro-trous (12) et les trous de liaison (132) de la plaque de commutation (13, 23), dans lequel les fils (18) relient électriquement la plaque à micro-trous (12) aux points de contact supérieurs (131) de la surface supérieure (13U) de la plaque de commutation (13, 23) ;
une pluralité de traces de circuit externes (37) pour connecter respectivement et électriquement les points de contact supérieurs (131) de la plaque de commutation (13, 23) aux points de contact supérieurs de la surface supérieure (31U) de la carte de circuit imprimé de test (31) ; et
dans lequel une distance entre deux trous de liaison (132) adjacents de la plaque de commutation (13, 23) est supérieure à une distance entre deux premiers micro-trous (121) adjacents de la plaque à micro-trous (12), et un rapport entre une longueur d'un fil le plus long des fils (18) et une longueur d'un fil le plus court des fils (18) est inférieur à 1,1 ; **caractérisé en ce que** le module de commutation (10, 20) comprend en outre :
un film de positionnement (19), disposé entre la plaque à micro-trous (12) et la plaque de commutation (13, 23) et au-dessus des premiers micro-trous (121) de la plaque à micro-trous (12), dans lequel le film de positionnement (19) comprend une pluralité de seconds micro-trous (191) correspondant respectivement aux premiers micro-trous (121), les fils (18) passent respectivement à travers les seconds micro-trous (191) du film de positionnement (19), une distance entre deux trous de liaison (132) adjacents de la plaque de commutation (13, 23) est supérieure à une distance entre deux seconds micro-trous (191) adjacents du film de positionnement (19), et la distance entre deux seconds micro-trous (191) adjacents du film de positionnement (19) est égale à la distance entre deux premiers micro-trous (121) adjacents de la plaque à micro-trous (12).

2. Module de commutation (10) selon la revendication 1, dans lequel une distance entre la surface supérieure (13U) de la plaque de commutation (13) et une surface supérieure de la plaque à micro-trou (12) est supérieure à 4 mm.

3. Module de commutation (10) selon la revendication 1, dans lequel un ensemble de positions de contact entre les fils (18) et la surface inférieure (13B) de la plaque de commutation (13) forme une région de soudure circulaire, un rayon de la région de soudure circulaire est défini comme R, une distance entre la surface inférieure (13B) de la plaque de commutation (13) et une surface supérieure de la plaque à micro-trous (12) est définie comme L, et une valeur de R/L se situe dans une plage comprise entre 0,1 et 7,5.

4. Module de commutation (10) selon la revendication 1, dans lequel un ensemble de positions de contact entre les fils (18) et la surface inférieure (13B) de la plaque de commutation (13) forme une région de soudure rectangulaire, une longueur latérale de la région de soudure rectangulaire est définie comme 2R, une distance entre la surface inférieure (13B) de la plaque de commutation (13) et une surface supérieure de la plaque à micro-trous (12) est définie comme L, et une valeur de R/L se situe dans une plage comprise entre 0,1 et 7,5.

5. Carte à sonde (30) comprenant :
une carte de circuit imprimé de test (31) comprenant une surface supérieure (31U), une surface inférieure (31B) et un trou central (311) ;
un élément de renforcement (32) disposé sur la surface supérieure (31U) de la carte de circuit imprimé de test (31), dans laquelle l'élément de renforcement (32) comprend un support central (321) correspondant au trou central (311) ;
un module de commutation (10, 20) selon l'une quelconque des revendications 1 à 5, dans laquelle le module de commutation (10, 20) est reçu dans le support central (321) de l'élément de renforcement (32), et dans laquelle les fils (18) ne se croisent pas et ont une longueur uniforme

6. Carte à sonde (30) selon la revendication 5, dans laquelle la plaque de commutation (13, 23) comprend une région centrale (13C, 23C) et une région de bord (13E, 23E) entourant la région centrale (13C, 23E), et les points de contact supérieurs (131) se trouvent dans la région de bord (13E, 23E).

7. Carte à sonde (30) selon la revendication 6, dans laquelle une projection de la zone de bord (13E, 23E) dans une direction normale de la plaque de commutation n'est pas chevauchée par la partie creuse (111) de la base (11).

8. Carte à sonde (30) selon la revendication 7, dans laquelle la plaque de commutation (13, 23) comprend en outre un schéma de circuit à couche interne (13L) située entre la surface supérieure (13U) et la surface inférieure (13B), les fils (18) étant connectés électriquement aux points de contact supérieurs (131) de la plaque de commutation (13, 23) par l'intermédiaire du schéma de circuit à couche interne (13L).

9. Carte à sonde (30) selon la revendication 6, dans laquelle le module de commutation (10, 20) comprend en outre une pluralité de traces de circuit intermédiaires (27), la plaque de commutation (13, 23) comprend en outre une région centrale (13C, 23C) et une région de bord (13E, 23E) entourant la région centrale (13C, 23C) ; les points de contact supérieurs de la plaque de commutation (13, 23) sont divisés en une pluralité de premiers points de contact supérieurs (231C) et une pluralité de seconds points de contact supérieurs (231E), les premiers points de contact supérieurs (231C) se trouvent dans la région centrale (13C, 23C) et les seconds points de contact supérieurs (13E, 231E) se trouvent dans la région de bord (13E, 23E) ; les fils (18) relient électriquement la plaque à micro-trous (12) aux premiers points de contact supérieurs (231C) de la plaque de commutation (13, 23), et les traces de circuit intermédiaires (27) relient électriquement les premiers points de contact supérieurs (231C) aux seconds points de contact supérieurs (231E).

10. Carte à sonde (30) selon la revendication 6, dans laquelle une projection de la zone de bord (13E, 23E) dans une direction normale de la plaque de commutation n'est pas chevauchée par la partie creuse (111) de la base (11).

11. Carte à sonde (30) selon la revendication 6, dans laquelle un matériau des fils (18) est différent d'un matériau des traces de circuit externes (37) et est différent d'un matériau des traces de circuit intermédiaires (13L).

12. Carte à sonde (30) selon la revendication 5, dans laquelle une surface intérieure du support central (321) comporte un rebord (323) en butée contre une périphérie extérieure (119) de la base (11).

13. Carte à sonde (30) selon la revendication 5, dans laquelle la plaque à micro-trous (12) est exposée depuis la surface inférieure (31B) de la carte de circuit imprimé de test (31).

14. Carte à sonde (30) selon la revendication 5, dans laquelle un diamètre extérieur de la plaque de commutation (13, 23) est supérieur à un diamètre de trou du trou central (311) de la carte de circuit imprimé de test (31).
